# EUROPEAN PATENT SPECIFICATION

(11) **EP 3 872 984 B1**
(45) Date of publication and mention of the grant of the patent: **06.12.2023**
(21) Application number: 21168979.9
(22) Date of filing: 12.08.2019
(51) Int. Cl.: H01L 31/048, H02S 20/00

(54) **A SOLAR POWER PLANT**
SOLARKRAFTWERK
CENTRALE SOLAIRE

(30) Priority: 24.08.2018 GB 201813842
(43) Date of publication of application: 01.09.2021
(62) Divisional of application: 19766116.8
(73) Proprietor: Ocean Sun AS, 1360 Fornebu (NO)
(72) Inventor: Bjørneklett, Børge, 1359 Eiksmarka (NO)
(74) Representative: Zacco Norway AS

(56) References cited:
- WO-A1-2018/022655
- US-A1- 2010 065 106
- Ocean Sun: "Pilot installation celebrates one year | Ocean Sun", , 13 May 2018 (2018-05-13), XP055802216, Retrieved from the Internet: URL:https://oceansun.no/pilot-installation -celebrates-one-year/ [retrieved on 2021-05-06]
- Ocean Sun: "Ocean Sun new system", , 31 July 2018 (2018-07-31), XP055802281, Retrieved from the Internet: URL:https://oceansun.no/new-system/ [retrieved on 2021-05-06]

## Description

The present invention relates to renewable energy production, and more specifically to apparatus relating to floating solar power plants including a plurality of photovoltaic modules mounted on a flexible web or membrane.

### BACKGROUND

Floating photovoltaic (PV) solar power systems are known, although not extensively used at present. Such systems are typically deployed on calm water, i.e. on lakes, hydroelectric power dams, water reservoirs, rivers, or the like. Some of the challenges associated with floating solar power systems include exposure to loads from waves and currents, challenging and labour-intensive deployment of the plant (or components thereof), and problems associated with access for system maintenance and cleaning (e.g. salt or solid particles accumulating on plant surfaces). Currently available floating solar power systems are also limited by their relatively high cost.

Examples of prior art which may be useful for understanding the background include: US 2012/0242275 A1, which describes a large-scale ocean mobile solar power generation system; US 2015/0162866 A1, which describes a supporting device for a solar panel; US 2014/0224165 A1, which describes a device for supporting a photovoltaic panel; KR 1011013316 B and KR 101612832 B, which describe solar cells arranged on floating devices; and WO2017/209625, which discloses a solar power plant comprising a plurality of stiff PV modules on a flexible membrane which is, in use, floated on the surface of a body of water. A further example of a floating solar power plant is disclosed in document: Ocean Sun: "Ocean Sun new system", 31 July 2018 (2018-07-31), retrieved from the Internet:URL:https://oceansun.no/new-system/

At present there are both technical and economic challenges associated with floating PV power plants. There is consequently a need for improved systems and methods for such renewable power generation for a variety of applications and purposes. The present invention aims to provide improved apparatuses and methods relating to floating solar power plants, providing advantages and/or remedying current challenges or disadvantages associated with known systems and techniques.

### SUMMARY

According to one aspect we provide a solar power plant comprising a pliable mat arranged floating on a body of water, the mat having a plurality of photovoltaic (PV) modules fixed thereon, each module comprising a layer of photovoltaic cells sandwiched between an upper glass plate and a lower glass plate, and being secured to the mat such that the lower plate lies on or directly adjacent a top surface of the mat.

The lower plate may have a thickness between 0.5 mm and 4 mm, between 1 mm and 3 mm, or about 2.5 mm.

The upper plate may have a thickness between 0.5 mm and 4 mm, between 1 mm and 3 mm, or about 2.5 mm.

The upper and lower plates may have the same thickness.

The mat may have has a thickness of between 0.3 mm and 5 mm, between 0.5 mm and 1.5 mm, or about 1 mm.

At least one of the PV modules may be secured to the mat by means of an attachment assembly comprising an elongate module profile secured to an edge fo the PV module, and a corresponding elongate mat profile attached to the mat.

At least one of the PV modules may be secured to the mat by means of an attachment assembly comprising two elongate module profiles secured to two generally parallel opposite edges of the PV module 1, and two corresponding elongate mat profiles attached to the mat.

The profiles may be configured such that the PV module is secured to the mat by bringing the profiles on the PV modules into contact with the corresponding profile on the mat, and sliding the profiles relative to one another in a direction generally parallel to the edge of the PV module to which the module profile is secured, until they reach a desired end position in which separation of the two profiles by the application of a force generally perpendicular to the edge of the PV module is substantially prevented.

A fastener may be provided, when engaged, the fastener preventing any further relative movement of the two profiles generally parallel to the edge of the PV module.

The module profiles may be adhesively bonded to the edges of the PV module.

The mat profiles may be welded or sewn to the mat.

The module profile may include an elongate retaining feature which extends generally parallel to the edge of the PV module to which it is attached.

The retaining feature may be connected to the PV module by means of an elongate frame part having two generally parallel legs connected by a base part.

The legs may be secured to the lower and upper glass plates by means of an adhesive.

The frame part may be integral with the retaining feature.

The module profile may extend along the entire edge of the PV module.

The mat profile may include an elongate retaining feature which is configured to mate with the retaining feature of the module profile and which is secured to the mat using a web. The web may ensure that the separation between the mat and the retaining feature is generally constant along substantially the entire length of the retaining feature.

One of the retaining features may have a male part which is inserted into a corresponding female part of the other retaining feature.

The male part may comprise an elongate tube or rod, whilst the female part comprises an elongate tube having a split which extends parallel to its longitudinal axis.

The mat may be fixed to a floatation element.

The floatation element may be an endless, elongated floatation element which surrounds the mat.

According to the first aspect, each module may be substantially stiff by means of the upper plate being a stiff plate, the lower plate being a stiff plate, or both the upper and lower plates being stiff plates. The modules may advantageously not be compliant to folding or bending.

According to the first aspect, the modules may be separate modules which are not interconnected, but fixed only to the mat. Each module may be spaced from other modules.

According to the first aspect, the modules may be arranged in an x-y pattern, with rows and columns of modules, each row and each column comprising a plurality of individual modules.

According to the first aspect, each module may comprise one or more junction boxes for electric distribution. The junction boxes may be positioned on a top surface of the respective module, on a side surface of the module, or on the elongate module profiles.

### BRIEF DESCRIPTION OF THE DRAWINGS

Illustrative embodiments will now be described with reference to the appended drawings, in which:
Fig. 1 shows a diagrammatic view of a solar power plant according to the described aspect of the invention floating in the sea,
Fig. 2 shows a schematic illustration of a transverse cross-section through a portion of photovoltaic (PV) module suitable for use in a solar power plant according to the described aspect of the invention,
Fig. 3 shows an exploded view of a PV module suitable for use in a solar power plant according to the described aspect of the invention,
Fig. 4 shows a cross section of an edge of the PV module illustrated in Figures 2 & 3 attached to a pliable mat using an attachment assembly,
Fig. 5 shows an alternative embodiment of attachment assembly,
Fig.6 shows a further alternative embodiment of attachment assembly,
Fig. 7 shows a plan view of a PV module suitable for use in a solar power plant according to the described aspect of the invention, and
Fig. 8 shows a schematic illustration of an offshore solar power plant according to the first described aspect of the invention.
Figs 9 and 10 show embodiments of a module comprising more junction boxes.

### DETAILED DESCRIPTION

Many fixed or floating offshore units such as oil and gas production platforms, drilling or processing installations require considerable amounts of energy to operate. Other demanding installations include large fish farms, or populated islands that are located far from the grid. The energy demand for these sites is commonly supplied via diesel or gas turbine generators. Due to the high energy consumption originating from fossil fuel sources and the subsequent release of carbon dioxide, the activity has raised considerable debate among environmentalists and politicians. Additionally, the cost of energy is an important consideration by operators and owners of such installations.

According to embodiments described herein, there is provided a floating renewable power generation installation suitable for connection to a regular, land-based electricity grid through a cable, or for standalone, off-grid power generation. Embodiments may be employed in remote or near-shore offshore locations or on inland waters and can, for example, be designed to replace fossil fuel based generators or power plants and thereby reduce the CO₂ footprint of the electric power generation. For example, many densely populated areas, including many megacities, are located near shore. In such areas, the available area or useable rooftops for conventional renewables, such as wind power and solar, is very limited. According to embodiments described herein, significant contributions can be made to renewable power generation in such areas, at moderate cost and with high operational reliability.

Embodiments of the system are suitable for a variety of applications, and can, for example, be designed to replace or provide a substantial part of the energy demand during daytime in the spring, summer and autumn. For example, PV may work well in hybrid power systems where flexible fuel based generators easily can level out the typical irregularities that occur with the shifting output from solar energy systems due to clouds and the position of the sun. Alternatively, batteries may also be used for energy storage.

The invention comprises a solar power plant comprising a plurality of PV modules 1 installed onto a flexible membrane or web, hereinafter referred to as a mat 2, to form a PV array. The PV array is buoyant, and so can float on the surface of a body of water such as the sea, to form an offshore solar power plant. In order to achieve this, the mat 2 may be made at least partly of a buoyant material, and / or the PV array may further comprise floatation elements which are fixed to or incorporated into the mat 2. Various ways of achieved this buoyancy are described in WO2017/209625.

The substrate mat 2 is fully flexible, essentially follows the motion of the sea waves and generally display a so-called hydro-elastic behaviour. Chopped waves and sea spray is effectively prevented by the presence of the mat 2, which may cover large areas. A plurality of mats 2 may also be interconnected.

The mat 2 may or may not be perforated, have recesses, one-way valves, pumps or other arrangements to allow drainage of water accumulated on the uppermost surface of the mat (such as rain water). The mat 2 may alternatively be made of a net, i.e. have relatively large openings. If desirable, the buoyancy of the mat 2 can be designed to maintain a thin film of water on top of parts of or substantially the entire mat 2. This may be beneficial for cooling of the mat 2 itself and/or the PV modules 1.

In a preferred embodiment, the mat 2 has a thickness between 0.3 mm and 5 mm, more preferably between 0.5 mm and 1.5 mm, most preferably about 1 mm. Typical tolerances for these figures may be +/- 0.2 mm.

The mats 2 can be constructed from sheet, a net, woven textile, film or plate from e.g. polyethylene, polypropylene, polyurethane, EVA, synthetic rubber or copolymers which can be fabricated in large sections. Alternatively, the fabric may also be multi-layered and or partially inflated by pockets or elongate tunnels containing gas, water having low salinity, buoyant solids, oils, jellies, foam or other components. In one preferred embodiment, the mat 2 is a polymer coated textile membrane. Multiple polymers may be used, e.g. different polymers on each side of the mat 2, and/or layers of different polymers making up the polymer coating.

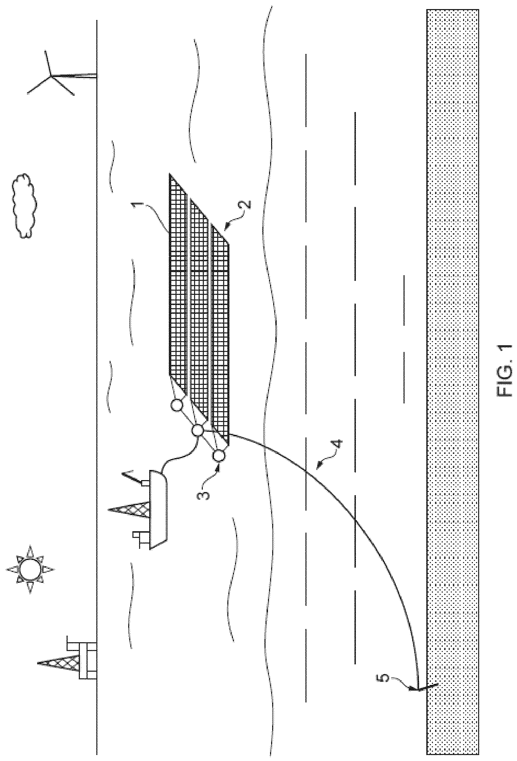

As mentioned above, the PV array can be designed with enough buoyancy to float, with the back side of the PV modules 1 partially submerged, enabling heat transfer with the water. The PV modules 1 may or may not be buoyant themselves. The module strings 2, or multiple strings forming an array, are moored to the seabed by anchors 5, chains and in combination with light weight rope 4 made of e.g. polyester or nylon. Alternative means of mooring is also possible, for example the module strings 2 can be fixed to land, e.g. in near-shore or dam applications. In the embodiment illustrated in Figure 1, buoys 3 are also installed to prevent the PV installation to be dragged under by sea current and/or wave drift forces. The geometry as well as the number and size of the anchors 5 and buoys 3 can be designed to minimise lateral drift forces. Adequate buoyancy and fixation points for anchoring can also be provided by one or several endless tubular elements encompassing the perimeter of the mat. The buoys 3 may also be equipped with appropriate lanterns to mark the location of the power plant for seafarers.

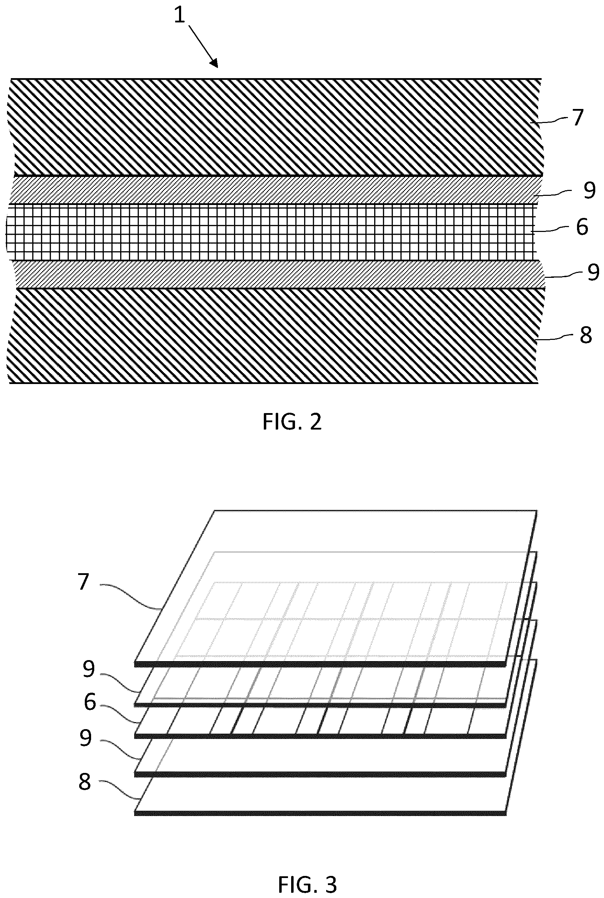

The PV modules 1 in this embodiment are dual glass modules comprising a layer of solar cells 6 sandwiched between an upper plate 7 and a lower glass plate 8, as illustrated in Figures 2 & 3.

The upper plate 7 preferably has a thickness between 0.5 mm and 4 mm, more preferably between 1 mm and 3 mm, and even more preferably about 2.5 mm.

The lower plate 8 preferably has a thickness between 0.5 mm and 4 mm, more preferably between 1 mm and 3 mm, and even more preferably about 2.5 mm.

According to the invention, the upper plate 7 and the lower plate 8 are both glass plates.

In one embodiment, the upper plate 7 and the lower plate 8 have the same thickness.

The inventor has discovered that a design with these configurations and thicknesses provide a particularly advantageous performance of the PV module when used offshore, while ensuring structural reliability and long lifetime.

The layer of solar cells 6 typically consist of multiple solar cells that are connected in series by metallic conductors soldered onto front and backside of the cells. For example, several strings of standard 6 x 6 inch solar cells may be arranged in an array of 6 x 10 or 6 x 12 cells and then interconnected.

In this example, the solar cells are laminated in between two layers of EVA (ethylene vinyl acetate) 9, the laminated solar cells between sandwiched between the upper and lower plates.

In order to protect the layer of solar cells from water ingress, a layer of sealant, typically EVA, is applied to the edges 1a around the entire perimeter of the PV module 1.

The PV modules 1 are interconnected electrically using high quality, non-degradable contacts capable of submersion. Each PV module 1 can be fitted with one or several smaller junction boxes (JB) for the plus and minus conductors as well as diodes separating individual strings of cells. Furthermore, the electrical cables can optionally be mechanically attached to the PV module 1 in order to strengthen the stress relief properties beyond what is offered by regular junction box terminals.

Depending on the size of the PV array, number of PV modules 1, designed peak wattage etc., the PV array is connected to inverters capable of transforming the power to the intended onshore or offshore consumer. If the inverters and transformers are not installed directly at an end user's offshore facility, they can be encapsulated and made buoyant. The latter is particularly relevant for large area installation with e.g. multiple string inverters and where the power is delivered through a main power cable to the end user.

Not accounting for the JBs, the size of the dual glass module is typically in the range: thickness from 4 to 8 mm, width between 0.9 and 1 m and length between 1.6 and 1.7 meters.

In order to operate at maximum efficiency, over-heating of PV modules 1 should be avoided. Conventionally this is achieved by avoiding placing the back side of the PV module 1 against a thermal insulator, for example, by leaving it open to air circulation. When used in a floating PV array as described above, the lower plate 8 is in direct contact with the mat 2, which again is arranged on the body of water on which the array is floating. As such, the module 1 is cooled by the body of water. Such stable and effective cooling of the PV modules 1 may improve the efficiency of a solar power plant utilising such PV arrays. To further enhance the cooling of the PV module 1, the mat 2 may be arranged such that a small amount of water flows onto and is retained on its surface, or to be floating just slightly below the surface of the water, so that the lower plate 8 is in direct contact with the body of water.

The present invention may utilise a new way of installing a PV module 1 flat onto a pliable mat 2.

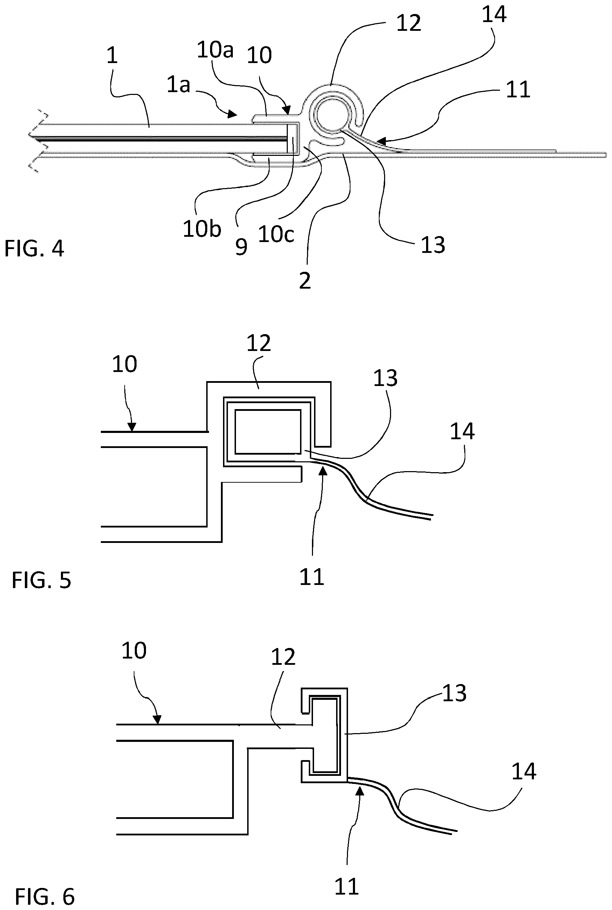

One embodiment of attachment assembly is illustrated in Figure 4. In this case, two elongate profiles 10 are secured to two generally parallel opposite edges 1a of the PV module 1, and are designed to engage with corresponding elongate profiles 11 attached to the mat 2, in order to secure the PV module 1 on the mat 2. The profiles 10, 11 are designed such that the PV module 1 is secured to the mat 2 by bringing the profiles 10 on the PV modules into contact with the corresponding profile 11 on the mat 2, and sliding the profiles relative to one another in a direction generally parallel to the edge 1a of the PV module 1 to which the profile 10 is secured until they reach a desired end position in which separation of the two profiles 10, 11 by the application of a force generally perpendicular to the edge 1a of the PV module 1 is substantially prevented. A fastener may then be applied to prevent any further relative movement of the two profiles generally parallel to the edge 1a of the PV module 1, at which point, the PV module 1 is secured to the mat 2. It will be appreciated that, by virtue of this arrangement, securing the PV modules 1 to the mat 2 is a relatively quick and simple process.

In the event that a PV module 1 needs to be replaced, this process can be reversed to remove the PV module 1 from the mat 2 quickly and easily. Moreover, the PV modules 1 are stackable, and by using such a quick release attachment assembly can easily be deployed or retracted in case of extreme weather.

In this embodiment, the elongate profiles 10 are adhesively bonded to the edges 1a of the PV module, whilst the elongate profiles 11 are welded or sewn to the mat 2.

The profile 10 secured to the PV module 1 may be made from a corrosion resistant metal such as anodised aluminium or stainless steel, whilst the profile secured to the mat 2 may be made from a polymer such as PVC or a composite material.

In this embodiment, the profile 10 attached to the PV module 1 includes a retaining feature 12 which extends generally parallel to the edge 1a of the PV module 1 to which it is attached. In the embodiment illustrated in Figure 4, the retaining feature 12 is connected to the PV module 2 by means of an elongate frame part having two generally parallel legs 10a, 10b connected by a base part 10c. The frame part is inserted over the edge 1a of the PV module 1 so that the edge 1a of the PV module 1 is sandwiched between the two legs 10a, 10b, and the EVA seal is sandwiched between the base 10c and the edge 1a of the PV module 1. The legs 10a, 10b are secured to the lower and upper glass plates 7, 8 by means of a layer of adhesive such as silicon glue. In this embodiment, the frame part is integral with the retaining feature 12.

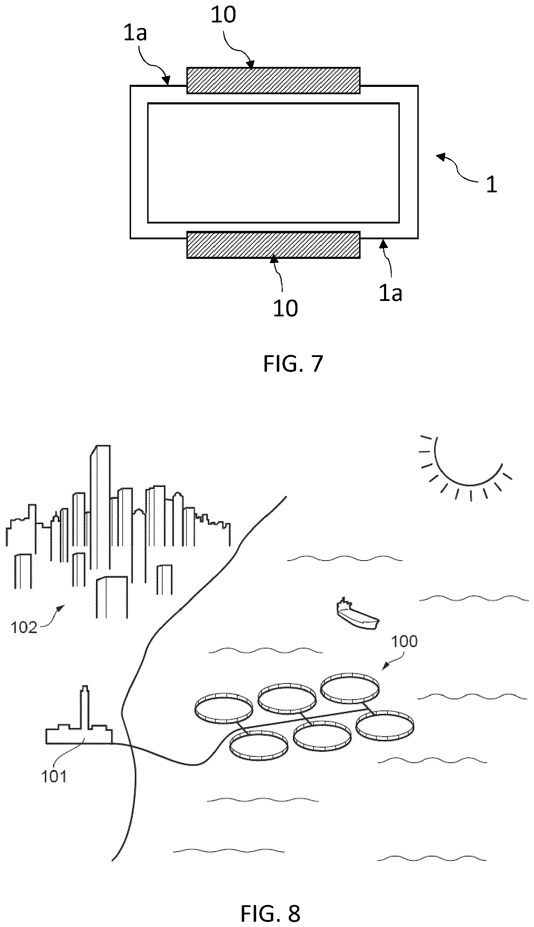

Advantageously, the profile 10 extends along the entire length of the edge 1a of the PV module 1, but this need not be the case. Equally, a plurality of shorter profiles 10 may be mounted on each or some of the edges 1a. A pair, or pairs, of profiles 10 may be fixed to the module 1 at opposite sides 1a of the module 1. This is illustrated schematically in Fig. 7.

In a preferred embodiment, each profile 10 has a length which is at least 40%, at least 50%, at least 60% or at least 70% of the length of the edge 1a. The module 1 may comprise exactly two such profiles 10, arranged at opposite edges 1a. Alternatively, the module 1 may comprise exactly four such profiles 10 arranged at opposite edges 1a, the combined length of two profiles 10 being at least 40%, at least 50%, at least 60% or at least 70% of the length of the edge 1a.

The profile 11 secured to the mat 2 includes a corresponding retaining feature 13 which is secured to the mat 2 using a web 14 which ensures that the separation between the mat 2 and the retaining feature 13 is generally constant along substantially the entire length of the retaining feature 13. One of the retaining features 12 may be a male part which is inserted into a corresponding female part of the other retaining feature 13.

For example, the male part could comprise an elongate tube or rod which is arranged so that its longitudinal axis extends generally parallel to the edge 1a of the PV module 1, whilst the female part comprises an elongate tube having a split which extends parallel to its longitudinal axis. The split may have an opening which is less than a width of the tube or rod.

This is the case in the embodiment illustrated in Figure 4 in which the female part forms part of the profile 10 which is secured to the PV module 1, whilst the male part forms part of the profile 11 which is secured to the mat 2. To secure the PV module 1 to the mat 2, the male part 13 of each profile 11 is inserted into an end of the female part 12 of each corresponding profile 10 with the web 14 extending through the split.

Also in the embodiment illustrated in Figure 4, the male part 13 is a tube with a generally annular transverse cross-section, whilst the female part 12 is a split tube with a generally C-shaped cross-section. It will be appreciated, however, that various configurations of parts, such as those illustrated in Figures 5 and 6, would be equally effective. For example, the male part could be a tube or rod with a square, rectangular or triangular transverse cross-section, and the female part a split tube with a correspondingly shaped transverse cross-section. Alternatively, the male part could have a generally T-shaped transverse cross-section, whilst the female part is a split tube with a generally rectangular cross-section. It should also be appreciated that the male part could equally be secured to the PV module 1 whilst the female part is secured to the mat 2, as in the example illustrated in Figure 6.

As mentioned above, once the female part is lodged in the desired position in the male part, preferably so that it is completely enclosed by the male part, a clip, screw or other fastener is then applied to prevent the female part from sliding out of the male part when the mat is in motion from waves, water current or installation personnel walking on the mat. This process is then repeated with the profiles 10, 11 on the opposite edge 1a of the PV module 1, to completely secure the PV module 1 to the mat 2.

In the embodiments described above, the retaining feature 13 is secured to the mat 2 by a flexible web 14, whilst the other retaining formation. Advantageously, to improve the ease of installation of the PV module 1, there is a small amount of slack in that web 14, so a limited amount of movement between the installed PV module 1 and the mat 2 is permitted when the PV module 1 is installed. It will be appreciated, however, that this could equally be achieved by connecting the retaining feature 12 to the PV module 1 by means of a flexible web, whilst the connection between retaining feature 13 and the mat 2 is rigid.

In an alternative embodiment, a dual glass PV module is equipped with one or several brackets. The bracket can have slits, holes or similar features that can serve as anchoring points for tying, folding or wrapping polymer bands or ropes to the module.

In a further alternative embodiment, the PV module is fastened as is with the aid of features in the mat itself. These can be pockets, velcro straps, zippers or the like that is integrated in the mat surface be thermoplastic welding, adhesive bonding or sewing.

Advantageously, a fixation arrangement according to embodiments described above may provide easier and safer installation and/or retrieval of the PV modules. Additionally, or alternatively, the profiles 10 and their arrangement reduce the structural load on the module 1 when subjected to e.g. wave motion, and may thus allow the use of material combinations and/or thicknesses for the upper and lower plates 7,8 which would otherwise not be possible, for example the use of a glass/glass combination. The profiles 10 can be fitted with rubber lining to avoid direct metallic contact. Overall, embodiments described herein thus reduce the risk of fracturing of the relatively brittle components of the modules 1 as well as other mechanical damage or fatigue.

The solar power plant is installed by deploying each PV array onto a body of water such as the sea, so that it floats at or on the surface of the body of water. This step may be carried out from a vessel or from the shore. Once installed in the desired location, the mat 2 may then be fixed to the seabed via a floating element as described above.

The PV modules may be secured to the mat 2 as described above, or removed from the mat, before the mat 2 is deployed onto the body of water, or when the mat 2 is floating on the surface of the body of water.

Where the PV array is deployed from or retrieved to a vessel, it may be transported on the vessel folded and stacked on board the vessel.

Figure 8 illustrates an embodiment of an offshore photovoltaic power plant 100. The power plant 100 is arranged in a near-shore location near a densely populated area 101, such as a city. The power plant 100 comprises a plurality of PV arrays as described above, which in this embodiment are mounted on circular mats 2. In the embodiment shown in Fig. 8, six units are moored near-shore. The power plant 100 is electrically connected to an onshore power station 101, for distribution of the produced electric power to the city 101 and/or to other onshore consumers via an onshore grid (not shown). An embodiment such as that shown in Figure 8 may therefore, for example, provide significantly more electrical power than what would be available from onshore solar power plants in view of the usually limited land area near densely populated areas.

The PV power plant may also be combined with batteries and preferably be used in combination with low energy density redox flow battery technology.

A PV power plant according to embodiments described herein may advantageously be combined with other offshore renewable power generators, such as wind turbine generators.

Embodiments of the invention can work well in combination with offshore wind parks where access to and from the windmills may be troublesome in rough sea. The presence of several large PV arrays as described above may have a calming effect on the sea in the vicinity of the offshore installations. It may, for example, prevent wind induced breaking of waves, ripples and chopped seas, whilst the individual PV modules 1 will experience slow heave motion when subjected to large swells. Dampening of waves, similar to the effect of oil on troubled waters or wave dampening from e.g. grease ice can have a profound influence on working environment and/or the overall fatigue life of offshore constructions. This improves service life of the wind power generators and reduces inspection and maintenance needs, while also easing access to the wind power generators. Solar PV also works well in combination with wind power due to overlapping power generation weather conditions during e.g. low wind and high solar radiation and vice versa. Furthermore, for such applications, the floating solar PV and offshore windmills may share a power cable infrastructure to land.

The PV power plant according to the embodiments described above could be used to provide electrical power for a fish farm, as described in WO2017/209625, for example.

Embodiments according to the present invention thus provide a novel and improved offshore photovoltaic power plant, and associated methods. According to some embodiments, installing such a power plant in harsh offshore environment can be made easier and more secure, at a reduced installation cost.

In some embodiments, the problem of reduced power production caused by heating of the solar cells can be reduced and a low cell operating temperature can be enabled, which increases the energy efficiency. The influence of waves on the installation, operation and structural integrity of the power plant may be lower than for known solutions, thus ensuring reliable and long life operation.

In any of the embodiments above, each module 1 may be substantially stiff by means of the upper plate 7 being a stiff plate, the lower plate 8 being a stiff plate, or both the upper and lower plates being stiff plates. By being substantially stiff, the modules are not compliant to folding or bending.

In any of the embodiments above, the modules may be separate modules which are not interconnected, but fixed only to the mat 2. Each module 1 may thus be spaced from other modules. By being spaced from each other, the modules 1 themselves are not physically linked. This may, for example, reduce the risk of damage to the modules 1 or to the PV cells arranged within the modules.

The modules 1 may, for example, be arranged in an x-y pattern, with rows and columns of modules, each row and each column comprising a plurality of individual modules 1.

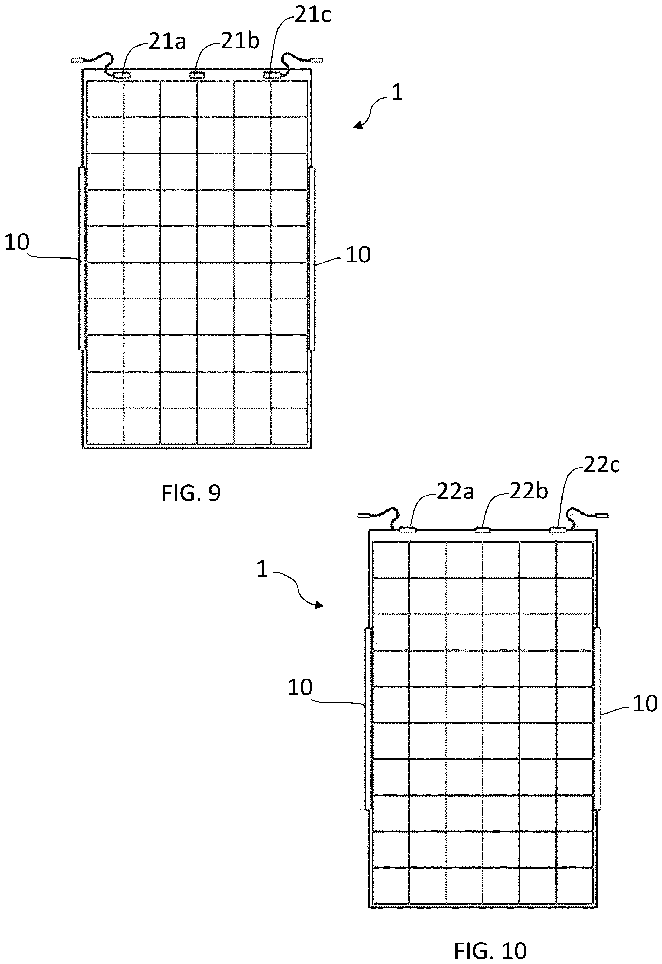

Illustrated in Figs 9 and 10, in any of the embodiments above, each module 1 may comprise one or more junction boxes 21a-c, 22a-c for electric distribution. The junction boxes may be positioned on a top surface, i.e. an upward-facing surface, of the module 1, as shown in Fig. 9 with junction boxes 21a-c. Alternatively, the junction boxes may be positioned on a side surface of the module 1, as shown in Fig. 10 with junction boxes 22a-c. Alternatively, the junction boxes may be positioned on the profiles 10 (this case is not illustrated).

Advantageously, by positioning the junction boxes in one of these configurations, one can achieve an uninterrupted flat surface between the module 1 and the mat 2. The junction boxes 22a-c, 23a-c can preferably be placed on or adjacent the side edges or the front face of the solar panel module 1, as seen in Figs 9 and 10.

## Claims

1. A solar power plant comprising a pliable mat (2) arranged floating on a body of water, the mat (2) having a plurality of photovoltaic (PV) modules (1) secured thereon, **characterized in that** each module (1) comprises a layer of photovoltaic cells (6) sandwiched between an upper glass plate (7) and a lower glass plate (8), and being secured to the mat (2) such that the lower glass plate (8) lies on or directly adjacent a top surface of the mat (2).

2. A solar power plant according to claim 1, wherein the lower glass plate (8) has a thickness between 0.5 mm and 4 mm, between 1 mm and 3 mm, or about 2.5 mm.

3. A solar power plant according to claim 2, wherein the upper glass plate (7) has a thickness between 0.5 mm and 4 mm, between 1 mm and 3 mm, or about 2.5 mm.

4. A solar power plant according to any preceding claim, wherein the upper and lower glass plates (7, 8) have the same thickness.

5. A solar power plant according to any preceding claim, wherein the mat (2) has a thickness between 0.3 mm and 5 mm, between 0.5 mm and 1.5 mm, or about 1 mm.

6. A solar power plant according to any preceding claim, wherein at least one of the PV modules (1) is secured to the mat (2) by means of an attachment assembly comprising an elongate module profile secured to an edges of the PV module (1), and a corresponding elongate mat profile attached to the mat (2).

7. A solar power plant according to any preceding claim, wherein the mat (2) is fixed to a floatation element.

8. A solar power plant according the preceding claim, wherein the floatation element is an endless, elongated floatation element which surrounds the mat (2).

9. A solar power plant according to any preceding claim, wherein each module (1) is substantially stiff by means of the upper and lower glass plates (7, 8) being stiff plates.

10. A solar power plant according to any preceding claim, wherein each module (1) comprises one or more junction boxes (21a-c,22a-c) for electric distribution, the junction boxes (21a-c,22a-c) positioned on an upward-facing surface or a side surface of the module (1).

11. A solar power plant according ot any preceding claim, wherein each of the plurality of modules (1) is fixed to the mat (2) so as to be spaced apart and disconnected from each other of the plurality of modules (1).

## Patentansprüche

1. Solarkraftwerk, umfassend eine biegsame Matte (2), die auf einem Gewässer schwimmend angeordnet ist, wobei die Matte (2) eine Vielzahl von Photovoltaikmodulen (PV-Modulen) (1) aufweist, die daran gesichert ist, **dadurch gekennzeichnet, dass** jedes Modul (1) eine Schicht aus Photovoltaikzellen (6) umfasst, die zwischen einer oberen Glasplatte (7) und einer unteren Glasplatte (8) eingelegt ist und an der Matte (2) derart gesichert ist, dass die untere Glasplatte (8) auf oder direkt benachbart zu einer oberen Fläche der Matte (2) liegt.

2. Solarkraftwerk nach Anspruch 1, wobei die untere Glasplatte (8) eine Dicke zwischen 0,5 mm und 4 mm, zwischen 1 mm und 3 mm oder von etwa 2,5 mm aufweist.

3. Solarkraftwerk nach Anspruch 2, wobei die obere Glasplatte (7) eine Dicke zwischen 0,5 mm und 4 mm, zwischen 1 mm und 3 mm oder von etwa 2,5 mm aufweist.

4. Solarkraftwerk nach einem vorhergehenden Anspruch, wobei die obere und die untere Glasplatte (7, 8) die gleiche Dicke aufweisen.

5. Solarkraftwerk nach einem vorhergehenden Anspruch, wobei die Matte (2) eine Dicke zwischen 0,3 mm und 5 mm, zwischen 0,5 mm und 1,5 mm oder von etwa 1 mm aufweist.

6. Solarkraftwerk nach einem vorhergehenden Anspruch, wobei mindestens eines der PV-Module (1) an der Matte (2) durch eine Anbringungsbaugruppe gesichert ist, die ein längliches Modulprofil, das an Kanten des PV-Moduls (1) gesichert ist, und ein entsprechendes längliches Mattenprofil, das an der Matte (2) angebracht ist, umfasst.

7. Solarkraftwerk nach einem vorhergehenden Anspruch, wobei die Matte (2) an einem Schwimmelement fixiert ist.

8. Solarkraftwerk nach dem vorhergehenden Anspruch, wobei das Schwimmelement ein unendliches längliches Schwimmelement ist, das die Matte (2) umgibt.

9. Solarkraftwerk nach einem vorhergehenden Anspruch, wobei jedes Modul (1) dadurch, dass die obere und die untere Glasplatte (7, 8) steife Platten sind, im Wesentlichen steif ist.

10. Solarkraftwerk nach einem vorhergehenden Anspruch, wobei jedes Modul (1) einen oder mehrere Anschlusskästen (21a-c, 22a-c) zur elektrischen Verteilung umfasst, wobei die Anschlusskästen (21a-c, 22a-c) an einer nach oben gewandten Fläche oder einer Seitenfläche des Moduls (1) positioniert sind.

11. Solarkraftwerk nach einem vorhergehenden Anspruch, wobei jedes der Vielzahl von Modulen (1) so an der Matte (2) fixiert ist, dass es von jedem anderen der Vielzahl von Modulen (1) beabstandet und getrennt ist.

## Revendications

1. Centrale solaire comprenant un tapis pliable (2) agencé de manière flottante sur une étendue d'eau, le tapis (2) sur lequel sont fixés une pluralité de modules photovoltaïques (PV) (1), **caractérisée en ce que** chaque module (1) comprend une couche de cellules photovoltaïques (6) prises en sandwich entre une plaque de verre supérieure (7) et une plaque de verre inférieure (8), et étant fixées au tapis (2) de sorte que la plaque de verre inférieure (8) repose sur une surface supérieure du tapis (2) ou directement à côté de celle-ci.

2. Centrale solaire selon la revendication 1, dans laquelle la plaque de verre inférieure (8) présente une épaisseur comprise entre 0,5 mm et 4 mm, entre 1 mm et 3 mm, ou d'environ 2,5 mm.

3. Centrale solaire selon la revendication 2, dans laquelle la plaque de verre supérieure (7) présente une épaisseur comprise entre 0,5 mm et 4 mm, entre 1 mm et 3 mm, ou d'environ 2,5 mm.

4. Centrale solaire selon une quelconque revendication précédente, dans laquelle les plaques de verre supérieure et inférieure (7, 8) présentent la même épaisseur.

5. Centrale solaire selon une quelconque revendication précédente, dans laquelle le tapis (2) présente une épaisseur comprise entre 0,3 mm et 5 mm, entre 0,5 mm et 1,5 mm, ou d'environ 1 mm.

6. Centrale solaire selon une quelconque revendication précédente, dans laquelle au moins un des modules PV (1) est fixé au tapis (2) au moyen d'un ensemble de maintien comprenant un profil de module allongé fixé à un bord du module PV (1), et un profil de tapis allongé correspondant fixé au tapis (2).

7. Centrale solaire selon une quelconque revendication précédente, dans laquelle le tapis (2) est fixé à un élément flottant.

8. Centrale solaire selon la revendication précédente, dans laquelle l'élément flottant est un élément flottant allongé et sans fin qui entoure le tapis (2).

9. Centrale solaire selon une quelconque revendication précédente, dans laquelle chaque module (1) est sensiblement rigide au moyen des plaques de verre supérieure et inférieure (7, 8) étant des plaques rigides.

10. Centrale solaire selon une quelconque revendication précédente, dans laquelle chaque module (1) comprend une ou plusieurs boîtes de jonction (21a à c, 22a à c) pour une distribution électrique, les boîtes de jonction (21a à c, 22a à c) étant positionnées sur une surface tournée vers le haut ou une surface latérale du module (1).

11. Centrale solaire selon une quelconque revendication précédente, dans laquelle chacun de la pluralité de modules (1) est fixé au tapis (2) de manière à être espacé et déconnecté les uns des autres parmi la pluralité de modules (1).
